# EUROPÄISCHE PATENTANMELDUNG

(11) **EP 4 235 771 A1**
(43) Veröffentlichungstag der Anmeldung: **30.08.2023**
(21) Anmeldenummer: 22158230.7
(22) Anmeldetag: 23.02.2022
(51) Int. Cl.: H01L 23/473

(54) **HALBLEITERANORDNUNG MIT ZUMINDEST EINEM HALBLEITERELEMENT, EINER ERSTEN MATERIALLAGE UND EINER ZWEITEN MATERIALLAGE**

(71) Anmelder: Siemens Aktiengesellschaft, 80333 München (DE)
(72) Erfinder: Danov, Vladimir, 91056 Erlangen (DE); Kneißl, Philipp, 90427 Nürnberg (DE); Müller, Volker, 90459 Nürnberg (DE); Neugebauer, Stephan, 91058 Erlangen (DE); Schwarz, Florian, 90766 Fürth (DE)
(74) Vertreter: Siemens Patent Attorneys

(57) **Zusammenfassung**

Die Erfindung betrifft eine Halbleiteranordnung (2) mit zumindest einem Halbleiterelement (4), einer ersten Materiallage (6) und einer zweiten Materiallage (8), wobei das zumindest eine Halbleiterelement (4) zwischen den Materiallagen (6, 8) angeordnet und mit der ersten Materiallage (6) und/oder der zweiten Materiallage (8), insbesondere stoffschlüssig, verbunden ist. Um die Zuverlässigkeit der Halbleiteranordnung (2) bei einer hohen Integrationsdichte zu verbessern, wird vorgeschlagen, dass die erste Materiallage (6) einen ersten Kühlkanal (10) und die zweite Materiallage (8) einen zweiten Kühlkanal (12) aufweist, wobei der zweite Kühlkanal (10) mit dem ersten Kühlkanal (12) in einer fluidtechnischen Verbindung steht.

## Beschreibung

Die Erfindung betrifft eine Halbleiteranordnung mit zumindest einem Halbleiterelement, einer ersten Materiallage und einer zweiten Materiallage, wobei das zumindest eine Halbleiterelement zwischen den Materiallagen angeordnet und mit der ersten Materiallage und/oder der zweiten Materiallage, insbesondere stoffschlüssig, verbunden ist.

Ferner betrifft die Erfindung einen Stromrichter mit mindestens einer Halbleiteranordnung nach einem der vorherigen Ansprüche.

Darüber hinaus betrifft die Erfindung ein Verfahren zur Herstellung einer Halbleiteranordnung mit zumindest einem Halbleiterelement, einer ersten Materiallage und einer zweiten Materiallage, wobei das zumindest eine Halbleiterelement zwischen den Materiallagen angeordnet und mit der ersten Materiallage und/oder der zweiten Materiallage, insbesondere stoffschlüssig, verbunden wird.

Derartige Anordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Die Halbleiteranordnungen in einem Stromrichter sind unter anderem mittels einer planaren Aufbau- und Verbindungstechnik realisierbar.

Die Offenlegungsschrift WO 2018/202439 A1 beschreibt eine elektronische Baugruppe mit einem Bauelement, welches zwischen einem ersten Substrat und einem zweiten Substrat gehalten ist. Erfindungsgemäß ist vorgesehen, dass ein Spalt zwischen dem ersten Substrat und dem Bauelement mit einem Durchgangsloch verbunden ist, so dass durch das Durchgangsloch hindurch beispielsweise ein Lotwerkstoff unter Ausnutzung von im Durchgangsloch und im Spalt wirkenden Kapillarkräften dosiert werden kann. Dabei erfolgt die Dosierung automatisch, da die Kapillarkräfte nur im Spalt wirken. Vorteilhaft lässt sich durch die automatische Dosierung des Lotwerkstoffs ein Toleranzausgleich bewerkstelligen, der aufgrund unterschiedlicher Spaltmaße notwendig werden kann.

Die Offenlegungsschrift WO 2019/015901 A1 beschreibt eine elektrische Baugruppe, die wenigstens ein elektronisches Schaltelement aufweist, das an seiner Unterseite und an seiner dieser gegenüberliegenden Oberseite elektrisch kontaktiert ist. Die elektrische Baugruppe weist zudem zwei einander gegenüberliegend an den elektrischen Kontaktierungen angeordnete Verdrahtungsträger auf. Diese Verdrahtungsträger sind jeweils wenigstens zum Teil aus einem dauerelastischen, elektrisch isolierenden, thermisch leitfähigen Material gebildet.

Die Offenlegungsschrift WO2020249479A1 beschreibt einen elektronischen Schaltkreis mit einem ersten und einem zweiten Schaltungsträger sowie einem ersten und einem zweiten Halbleiterbauelement. Das erste Halbleiterbauelement liegt mit einer Oberseite an einer Unterseite des ersten Schaltungsträgers an sowie mit einer Unterseite an einer Oberseite des zweiten Schaltungsträgers. Der erste Schaltungsträger weist eine erste Durchkontaktierung auf, welche das erste Halbleiterbauelement mit einer ersten Leiterbahn verbindet. Der erste Schaltungsträger weist eine zweite Durchkontaktierung auf, welche ein zwischen den Schaltungsträgern angeordnetes Verbindungselement mit einer weiteren Leiterbahn elektrisch verbindet. Über das erste Verbindungselement wird eine stoffschlüssige Verbindung zwischen den Schaltungsträgern hergestellt. Das zweite Halbleiterbauelement liegt an der Unterseite des ersten Schaltungsträgers an und ist elektrisch mit der ersten oder zweiten Leiterbahn verbunden.

Durch eine zunehmende Miniaturisierung der Leistungselektronik in Stromrichtern, insbesondere unter Verwendung einer derartigen planaren Aufbau- und Verbindungstechnik, ergeben sich neue Herausforderungen hinsichtlich der Entwärmung einer Halbleiteranordnung, um eine hohe Zuverlässigkeit bei geringem Platzbedarf, auch unter Berücksichtigung der Herstellungskosten, zu gewährleisten.

Die Offenlegungsschrift EP 3 823 018 A1 beschreibt ein Elektronikmodul. Das Elektronikmodul umfasst eine pulsierende Heatpipe mit einer Kanalstruktur, in der ein Wärmetransportmedium angeordnet ist, und wenigstens ein elektrisches Bauelement, das mit dem Wärmetransportmedium direkt in Kontakt steht und/oder mit einem elektrisch leitfähigen Kontaktelement verbunden ist, das mit dem Wärmetransportmedium direkt in Kontakt steht.

Die Patentschrift US 6,923,362 B2 beschreibt einen inneren Kanal in einem Metallkörper zur Verwendung bei Anwendungen, bei denen eine innere Flüssigkeitsströmung innerhalb eines Metallkörpers erwünscht ist, wie in einem Wärmetauscher. Der innere Kanal wird in dem Metallkörper durch Reibungsrühren mit einem in den Metallkörper eingetauchten Stift gebildet und der Metallkörper wird mit dem Stift durchquert.

Vor diesem Hintergrund besteht die Aufgabe der vorliegenden Erfindung darin, eine Halbleiteranordnung anzugeben, welche eine hohe Zuverlässigkeit bei einer hohen Integrationsdichte aufweist.

Diese Aufgabe wird bei einer Halbleiteranordnung eingangs genannter Art erfindungsgemäß dadurch gelöst, dass die erste Materiallage einen ersten Kühlkanal und die zweite Materiallage einen zweiten Kühlkanal aufweist, wobei der zweite Kühlkanal mit dem ersten Kühlkanal in einer fluidtechnischen Verbindung steht.

Ferner wird die Aufgabe erfindungsgemäß gelöst durch einen Stromrichter mit mindestens einer derartigen Halbleiteranordnung.

Darüber hinaus wird die Aufgabe erfindungsgemäß bei einem Verfahren eingangs genannter Art dadurch gelöst, dass in der ersten Materiallage ein erster Kühlkanal und der zweiten Materiallage ein zweiter Kühlkanal hergestellt wird, wobei der zweite Kühlkanal mit dem ersten Kühlkanal fluidtechnisch verbunden wird.

Die in Bezug auf die Halbleiteranordnung nachstehend angeführten Vorteile und bevorzugten Ausgestaltungen lassen sich sinngemäß auf den Stromrichter und das Herstellungsverfahren übertragen.

Der Erfindung liegt die Überlegung zugrunde, die Zuverlässigkeit einer Halbleiteranordnung mit zumindest einem Halbleiterelement bei einer hohen Integrationsdichte zu erhöhen, indem die Entwärmung des zumindest einen Halbleiterelements verbessert wird. Das zumindest eine Halbleiterelement ist zwischen einer ersten Materiallage und einer zweiten Materiallage angeordnet und mit zumindest einer der beiden Materiallagen, insbesondere stoffschlüssig, verbunden. Eine derartige stoffschlüssige Verbindung kann unter anderem eine Lötverbindung und/oder eine Sinterverbindung aber auch eine adhäsive Verbindung, z.B. mit einem elektrisch und thermisch leitfähigen Kleber, sein. Die Materiallagen sind beispielsweise aus einem elektrisch leitfähigen, insbesondere metallischen, Werkstoff, z.B. aus Aluminium, Kupfer oder einer Legierung, welche unter Anderem Aluminium und/oder Kupfer enthalten kann, hergestellt. Die erste Materiallage ist beispielsweise als Stromschiene ausgeführt, während die zweite Materiallage als Kühlplatte ausgeführt ist. Ferner kann zumindest eine der beiden Materiallagen als Substrat, insbesondere als DCB-Substrat, ausgeführt sein. Das Halbleiterelement ist beispielsweise als vertikaler Halbleiter, insbesondere als ein Insulated-Gate-Bipolar-Transistor (IGBT), ausgeführt. Weitere Beispiele für derartige Halbleiterelemente sind unter anderem weitere Transistortypen wie Feldeffekttransistoren aber auch Triacs, Thyristoren und Dioden aber auch, insbesondere vollständige, Leistungsmodule. Ein derartiges Leistungsmodul kann unter anderem eine Mehrzahl von Schaltern, insbesondere Transistoren, enthalten. Ein Beispiel für ein derartiges Leistungsmodul ist unter anderem ein Halbbrückenmodul mit zumindest einer Halbbrücke. Um eine verbesserte Entwärmung zu ermöglichen, wird in die erste Materiallage ein erster Kühlkanal und in die zweite Materiallage ein zweiter Kühlkanal eingebracht, wobei der zweite Kühlkanal mit dem ersten Kühlkanal fluidtechnisch verbunden wird. Eine derartige fluidtechnische Verbindung kann unter anderem über zumindest ein Verbindungselement, ein Leitblech und/oder eine unmittelbare Verbindung zwischen der ersten Materiallage und der zweiten Materiallage erfolgen. Das Einbringen der Kühlkanäle kann beispielsweise mittels eines subtraktiven, insbesondere spanenden, Verfahrens und/oder mittels eines additiven Verfahrens erfolgen. Durch eine derartige Integration der Kanäle wird Bauraum eingespart. Durch die fluidtechnische Verbindung des ersten Kühlkanals der ersten Materiallage mit dem zweiten Kühlkanal der zweiten Materiallage wird eine große Fläche für einen thermischen Übergang bereitgestellt, was, insbesondere bei einer hohen Integrationsdichte zu einer Wärmespreizung und damit zu einer Verbesserung der Entwärmung des zumindest einen Halbleiterelements führt.

Eine weitere Ausführungsform sieht vor, dass die erste Materiallage mit der zweiten Materiallage über zumindest ein Verbindungselement verbunden ist, wobei das zumindest eine Verbindungselement einen dritten Kühlkanal aufweist, welcher zur Herstellung der fluidtechnischen Verbindung zwischen dem ersten Kühlkanal der ersten Materiallage und dem zweiten Kühlkanal der zweiten Materiallage vorgesehen ist. Ein derartiges Verbindungselement ist beispielsweise hohlzylinderförmig ausgeführt und kann unter anderem aus einem elektrisch isolierenden, insbesondere dielektrischen, Werkstoff, z.B. einem Kunststoff, oder aus einem elektrisch leitfähigen, insbesondere metallischen, Werkstoff hergestellt sein. Alternativ kann das Verbindungselement einen Metallteil mit einem, insbesondere angespritzten, Isolations-Einsatz aufweisen. Derartige Verbindungselemente können in der Halbleiteranordnung bereits vorhanden sein, sodass kein zusätzlicher Bauraum erforderlich ist. Durch die Integration des dritten Kühlkanals in ein Verbindungselement wird der erforderliche Bauraum für die Halbleiteranordnung reduziert. Derartige Verbindungselemente sind flexibel, insbesondere im Bereich von Hotspots, positionierbar, was zu einer Verbesserung der Entwärmung des zumindest einen Halbleiterelements beiträgt.

Eine weitere Ausführungsform sieht vor, dass das Verbindungselement aus einem elektrisch isolierenden Werkstoff, insbesondere einem dielektrischen Werkstoff, hergestellt und zur mechanischen Verbindung der ersten Materiallage mit der zweiten Materiallage vorgesehen ist. Beispielsweise ist das Verbindungselement aus einem Kunststoff, aus einem keramischen Werkstoff oder einem keramischen Kompositwerkstoff hergestellt. Neben einer mechanischen Funktion, beispielsweise einer Stützfunktion, übernimmt das Verbindungselement die Funktion der fluidtechnischen Verbindung zwischen dem ersten Kühlkanal der ersten Materiallage und dem zweiten Kühlkanal der zweiten Materiallage, was den erforderlichen Bauraum reduziert. Ferner sind, insbesondere aus Kunststoff hergestellte Verbindungselemente, kostengünstig herstellbar und die Einhaltung von Luft- und Kriechstrecken ist einfach sicherstellt.

Eine weitere Ausführungsform sieht vor, dass das Verbindungselement aus einem elektrisch leitfähigen Werkstoff, insbesondere einem metallischen Werkstoff, hergestellt und zur elektrisch leitfähigen Verbindung der ersten Materiallage mit der zweiten Materiallage vorgesehen ist. Ein derartiges metallisches Verbindungselement kann Kupfer, Aluminium, Silber, Gold, Zinn oder eine ihrer Legierungen enthalten. Neben seiner mechanischen Funktion, beispielsweise einer Stützfunktion, und der Herstellung der fluidtechnischen Verbindung zwischen dem ersten Kühlkanal der ersten Materiallage und dem zweiten Kühlkanal der zweiten Materiallage übernimmt das Verbindungselement die Funktion einer elektrisch leitfähigen Verbindung der ersten Materiallage mit der zweiten Materiallage, was den erforderlichen Bauraum zusätzlich reduziert. Ferner weisen, insbesondere Kupfer und Silber, eine sehr gute Wärmeleitfähigkeit auf, was sich positiv auf die Entwärmung des zumindest einen Halbleiterelements auswirkt.

Eine weitere Ausführungsform sieht vor, dass die Kühlkanäle ein elektrisch nichtleitendes Wärmetransportmedium enthalten, wobei das zumindest eine Halbleiterelement mit dem Wärmetransportmedium in einer thermisch leitfähigen Verbindung steht. Ein derartiges elektrisch nichtleitendes Wärmetransportmedium kann unter anderem Luft, deionisiertes Wasser oder ein technisches Fluid sein. Durch ein derartiges elektrisch nichtleitendes Wärmetransportmedium werden ungewollte Kurzschlüsse verhindert und es ergibt sich eine verbesserte Flexibilität beim Layout der Kanalstrukur.

Eine weitere Ausführungsform sieht vor, dass die Kühlkanäle mit dem Wärmetransportmedium für eine Zweiphasenkühlung vorgesehen sind. Eine derartige Zweiphasenkühlung schließt beispielsweise ein Thermosiphon, eine Heatpipe oder eine pulsierende Heatpipe (engl. pulsating heat pipe, PHP), welche auch als oszillierende Heatpipe (engl. oscillating heat pipe, OHP) bezeichnet wird, ein und ist, insbesondere im Vergleich zu einer rein konvektiven Kühlung, eine effiziente Kühlmethode.

Eine weitere Ausführungsform sieht vor, dass der erste Kühlkanal und/oder der zweite Kühlkanal mittels eines FSC-Verfahrens hergestellt ist. Beim FSC-Verfahren bzw. dem Friction Stir Channelling, auf Deutsch Rührreibkanalisieren genannt, handelt es sich um eine Weiterentwicklung des Rührreibschweißens, bei dem das Rührreibverfahren so modifiziert wird, dass das Material absichtlich aus der Masse des Werkstücks herausbewegt und so ein Kanal ausgebildet wird. Durch ein derartiges Verfahren sind Kühlkanäle, welche insbesondere über ein Verbindungselement fluidtechnisch verbindbar sind, einfach und kostengünstig herstellbar.

Eine weitere Ausführungsform sieht vor, dass der erste Kühlkanal und/oder der zweite Kühlkanal eine mittels des FSC-Verfahrens hergestellte Öffnung aufweisen, wobei das Verbindungselement über die Öffnung an den Kühlkanal angebunden ist. Eine derartige Öffnung entsteht während des FSC-Verfahrens üblicherweise als Nebenprodukt. Durch die Nutzung der Öffnung zur Anbindung des Verbindungselements, beispielsweise über eine stoffschlüssige Verbindung, wird der Herstellungsprozess weiter vereinfacht und die Herstellungskosten werden durch Reduzierung der Fertigungsschritte weiter gesenkt.

Eine weitere Ausführungsform sieht vor, dass die erste Materiallage und/oder die zweite Materiallage als ein Substrat ausgeführt ist, welches zumindest eine Metallisierung und eine dielektrische Materiallage umfasst. Die dielektrische Materiallage kann unter anderem einen keramischen Werkstoff, beispielsweise Aluminiumnitrid oder Aluminiumoxid, oder einen organischen Werkstoff, beispielsweise ein Polyamid oder Epoxidharz, enthalten. Eine derartige dielektrische Materiallage kann unter anderem zur Herstellung einer elektrisch isolierenden und thermisch leitfähigen Verbindung vorgesehen sein. Zumindest einer der Kühlkanäle kann durch eine dielektrische Materiallage und/oder durch eine Metallisierung eines Substrats verlaufend angeordnet sein. Durch eine derartige Integration wird der erforderliche Bauraum für die Halbleiteranordnung ohne merkliche Beeinträchtigung der Zuverlässigkeit reduziert.

Eine weitere Ausführungsform sieht vor, dass die zumindest eine Metallisierung eines Substrats als Dickkupfersubstrat ausgeführt ist. Ein derartiges Dickkupfersubstrat weist eine Kupferdicke von mindestens 1 mm auf. Zumindest einer der Kühlkanäle ist in das Dickkupfersubstrat integrierbar, sodass der erforderliche Bauraum für die Halbleiteranordnung reduziert wird, ohne die Zuverlässigkeit merklich negativ zu beeinträchtigen.

Im Folgenden wird die Erfindung anhand der in den Figuren dargestellten Ausführungsbeispiele näher beschrieben und erläutert.

Es zeigen:
- FIG 1: eine schematische Querschnittsdarstellung einer ersten Ausführungsform einer Halbleiteranordnung,
- FIG 2: eine schematische Querschnittsdarstellung einer zweiten Ausführungsform einer Halbleiteranordnung,
- FIG 3: eine schematische Querschnittsdarstellung einer dritten Ausführungsform einer Halbleiteranordnung,
- FIG 4: eine schematische Querschnittsdarstellung einer vierten Ausführungsform einer Halbleiteranordnung,
- FIG 5: eine schematische Querschnittsdarstellung einer fünften Ausführungsform einer Halbleiteranordnung,
- FIG 6: eine schematische Darstellung einer Herstellung eines Kühlkanals mittels eines FSC-Verfahrens und
- FIG 7: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

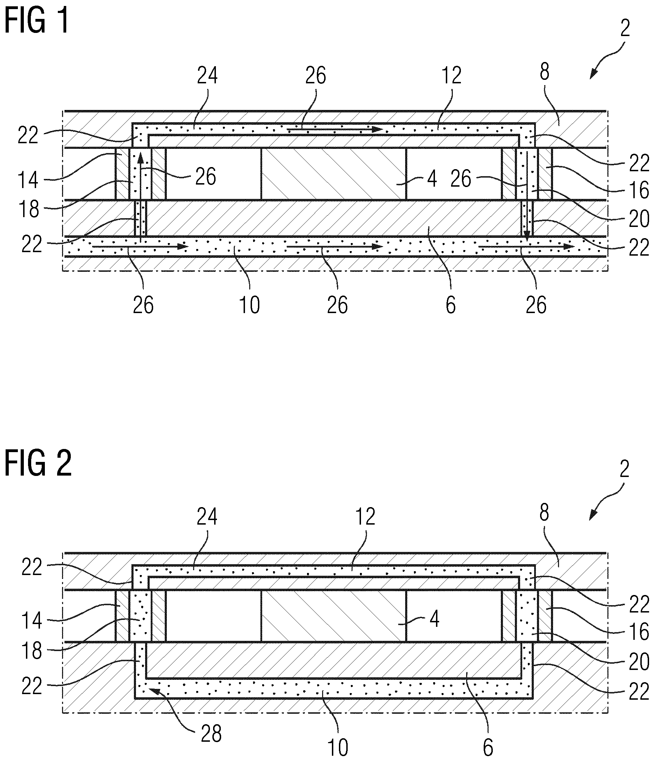

FIG 1 zeigt eine schematische Querschnittsdarstellung einer ersten Ausführungsform einer Halbleiteranordnung 2, welche ein Halbleiterelement 4, eine erste Materiallage 6 und eine zweite Materiallage 8 umfasst. Das Halbleiterelement 4 ist zwischen den Materiallagen 6, 8 angeordnet und mit diesen beispielsweise stoffschlüssig über eine Löt- und/oder eine Sinterverbindung, verbunden. Die Materiallagen sind beispielsweise aus einem elektrisch leitfähigen, insbesondere metallischen, Werkstoff, z.B. aus Aluminium, Kupfer oder einer Legierung, welche unter Anderem Aluminium und/oder Kupfer enthalten kann, hergestellt. Die erste Materiallage 6 ist beispielsweise als Stromschiene ausgeführt, während die zweite Materiallage 8 als Kühlplatte ausgeführt ist. Das Halbleiterelement 4 ist beispielsweise als ein Leistungsmodul, insbesondere als ein Halbbrückenmodul mit mindestens einer Halbbrücke, ausgeführt. Ein derartiges Leistungsmodul kann unter anderem eine Mehrzahl von Schaltern, insbesondere Transistoren, enthalten. Das Leistungsmodul ist beispielsweise über eine Schicht Wärmeleitpaste und mittels einer formschlüssigen Verbindung, insbesondere über eine Schraubverbindung, mit der Kühlplatte verbunden.

Alternativ kann das Halbleiterelement 4 als, insbesondere vertikaler, Halbleiter, z.B. als ein Insulated-Gate-Bipolar-Transistor (IGBT) oder weiterer Transistortyp, wie ein Feldeffekttransistor, aber auch als ein Triac, Thyristor oder Diode ausgeführt sein. Bei einer Ausführung als IGBT kann dieser beispielsweise kollektorseitig mit der Kühlplatte kontaktiert sein, während die Stromschiene mit dem Emitter verbunden ist. Ein Gate-Anschluss kann unter anderem mittels einer Bondverbindung oder einer weiteren Stromschiene kontaktiert sein.

Die erste Materiallage 6 weist einen ersten Kühlkanal 10 und die zweite Materiallage 8 einen zweiten Kühlkanal 12 auf. Der erste Kühlkanal 10 und der zweite Kühlkanal 12 können unter anderem einen runden, insbesondere elliptischen oder kreisförmigen, oder einen eckigen, insbesondere rechteckigen oder quadratischen Querschnitt aufweisen. Die Kanäle 10, 12 sind beispielsweise mittels eines FSC-Verfahrens in die jeweilige Materiallage 6, 8 eingebracht. Die erste Materiallage 6 ist mit der zweiten Materiallage 8 über Verbindungselemente 14, 16 verbunden. Die, insbesondere hohlzylinderförmigen, Verbindungselemente 14, 16 sind orthogonal zur ersten Materiallage 6 und zur zweiten Materiallage 8 angeordnet und können unter anderem aus einem elektrisch isolierenden, insbesondere dielektrischen, Werkstoff, z.B. einem Kunststoff, oder aus einem elektrisch leitfähigen, insbesondere metallischen, Werkstoff wie Kupfer, Aluminium, Silber, Gold, Zinn oder einer ihrer Legierungen hergestellt sein. Alternativ weisen die Verbindungselemente 14, 16 einen Metallteil mit einem angespritzten Isolations-Einsatz auf. Das erste Verbindungselement 14 weist einen dritten Kühlkanal 18 auf, während das zweite Verbindungselement 16 einen vierten Kühlkanal 20 aufweist, wobei der vierte Kühlkanal 20 parallel zum dritten Kühlkanal 18 verlaufend angeordnet ist. Der erste Kühlkanal 10 und der zweite Kühlkanal 12 weisen mittels des FSC-Verfahrens hergestellte Öffnungen 22 auf. Die Verbindungselemente 14, 16 sind über die Öffnungen 22 an den ersten Kühlkanal 10 und den zweiten Kühlkanal 12 angebunden. Der erste Kühlkanal 10 der ersten Materiallage 6 ist über seine Öffnungen 22, den dritten Kühlkanal 18 und den vierten Kühlkanal 20 fluidtechnisch mit den Öffnungen 22 des zweiten Kühlkanals 12 der zweiten Materiallage 8 verbunden. Innerhalb der Kühlkanäle 10, 12, 18, 20 ist ein Wärmetransportmedium 24 angeordnet. Das Wärmetransportmedium 24 ist als ein elektrisch nichtleitendes Fluid ausgeführt, um ungewollte Kurzschlüsse zu verhindern. Ein derartiges elektrisch nichtleitendes Fluid kann unter anderem Luft, deionisiertes Wasser oder ein technisches Fluid sein. Das Halbleiterelement 4 fungiert während des Betriebes als Wärmequelle, wobei ein Wärmetransport über eine Strömung 26 des Wärmetransportmediums 24 durch die Kühlkanäle 10, 12, 18, 20 stattfindet. Die Strömung 26 kann Teil eines Kühlkreislaufs sein.

FIG 2 zeigt eine schematische Querschnittsdarstellung einer zweiten Ausführungsform einer Halbleiteranordnung 2, wobei die Kühlkanäle 10, 12, 18, 20 eine geschlossene Kanalstruktur 28 mit einer Zweiphasenkühlung ausbilden. Auf diese Weise wird beispielsweise eine pulsierende Heatpipe ausgebildet. Hierbei bildet das Wärmetransportmedium 24 abwechselnd Dampfsegmente, in denen das Wärmetransportmedium 24 in einer gasförmigen Phase vorliegt, und Flüssigsegmente, in denen das Wärmetransportmedium 24 in einer gasförmigen Phase vorliegt. Die Dampfsegmente und Flüssigsegmente werden durch Temperaturgradienten zu pulsierenden beziehungsweise oszillierenden Bewegungen angeregt. Beispielsweise ist Perfluor-N-alkylmorpholin aufgrund seiner hohen Wärmeleitfähigkeit, seines Siedepunkts und seiner dielektrischen Eigenschaften gut als elektrisch nichtleitendes Wärmetransportmedium 24 für die Zweiphasenkühlung geeignet. Die weitere Ausgestaltung der Halbleiteranordnung 2 in FIG 2 entspricht der in FIG 1.

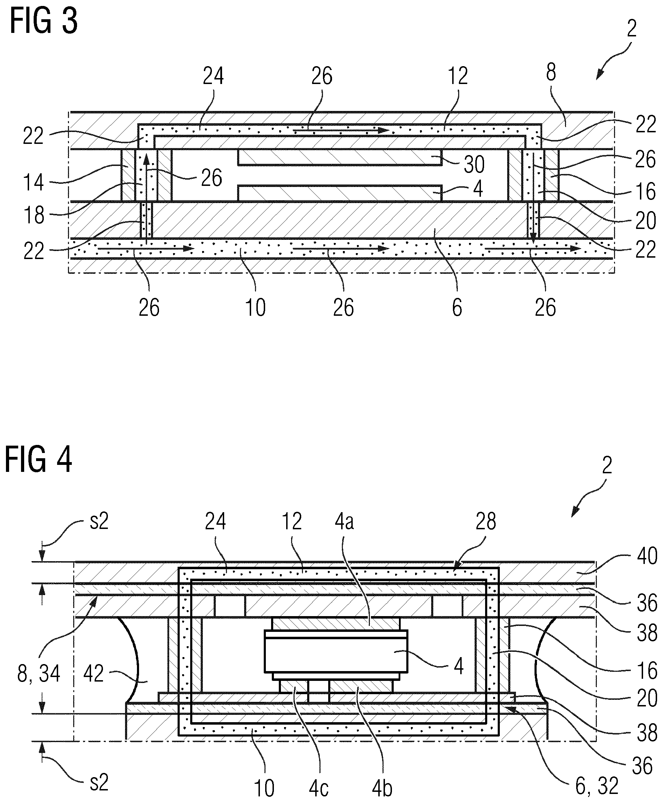

FIG 3 zeigt eine schematische Querschnittsdarstellung einer dritten Ausführungsform einer Halbleiteranordnung 2, wobei das Halbleiterelement 4 zwischen den Materiallagen 6, 8 angeordnet und mit der erste Materiallage 6 stoffschlüssig verbunden ist. Ein weiteres Halbleiterelement 30 ist ebenfalls zwischen den Materiallagen 6, 8 angeordnet und mit der zweiten Materiallage 8 stoffschlüssig verbunden. Beispielsweise sind das Halbleiterelement 4 und das weitere Halbleiterelement 30 jeweils als ein Leistungsmodul ausgeführt. Alternativ ist zumindest eines der Halbleiterelemente 4, 30 als ein, insbesondere vertikaler, Halbleiter, z.B. als ein IGBT ausgeführt, welcher über eine Löt- und/oder eine Sinterverbindung stoffschlüssig mit der jeweiligen Materiallage 6, 8 verbunden ist. Die weitere Ausgestaltung der Halbleiteranordnung 2 in FIG 3 entspricht der in FIG 1.

FIG 4 zeigt eine schematische Querschnittsdarstellung einer vierten Ausführungsform einer Halbleiteranordnung 2, wobei die erste Materiallage 6 als ein erstes Substrat 32 und die zweite Materiallage 8 als ein zweites Substrat 34 ausgeführt ist. Die Substrate 32, 34 weisen jeweils eine dielektrische Materiallage 36, eine auf einer dem Halbleiterelement 4 zugewandten Seite angeordnete erste Metallisierung 38 und eine auf einer dem Halbleiterelement 4 abgewandten Seite angeordnete zweite Metallisierung 40 auf. Die dielektrische Materiallage 36 kann unter anderem einen keramischen Werkstoff, beispielsweise Aluminiumnitrid oder Aluminiumoxid, oder einen organischen Werkstoff, beispielsweise ein Polyamid oder Epoxidharz, enthalten und stellt jeweils eine elektrisch isolierende und thermisch leitfähige Verbindung zwischen der ersten Metallisierung 38 und der zweiten Metallisierung 40 her.

Das Halbleiterelement 4 ist beispielhaft als vertikaler Leistungstransistor, insbesondere als Insulated-Gate-Bipolar-Transistor (IGBT), ausgeführt. Der Leistungstransistor ist über einen ersten Leistungsanschluss 4a, insbesondere über einen Kollektor-Anschluss, mit der ersten Metallisierung 38 des zweiten Substrats 34 verbunden. Auf einer dem ersten Leistungsanschluss 4a gegenüberliegenden Seite ist der Leistungstransistor über einen zweiten Leistungsanschluss 4b und einen Steueranschluss 4c mit der ersten Metallisierung 38 des zweiten Substrats 34 verbunden. Das erste Verbindungselement 14 und das zweite Verbindungselement 16 sind aus einem elektrisch leitfähigen, insbesondere metallischen, Werkstoff hergestellt. Das erstes Verbindungselement 14 ist zur elektrisch leitfähigen Verbindung des zweiten Leistungsanschlusses 4b mit der ersten Metallisierung 38 des zweiten Substrats 34 vorgesehen, während das zweite Verbindungselement 16 zur elektrisch leitfähigen Verbindung des Steueranschlusses 4c mit der ersten Metallisierung 38 des zweiten Substrats 34 vorgesehen ist. Zwischen den Substraten 32, 34 ist ein Vergussmaterial 42 angeordnet, in welchem das Halbleiterbauelement 4 sowie die Verbindungselemente 14, 16 eingebettet sind.

Das Wärmetransportmedium 24 ist als ein elektrisch nichtleitendes Fluid ausgeführt, um ungewollte Kurzschlüsse zu verhindern. Der erste Kühlkanal 10 und der zweite Kühlkanal 12 sind in der zweiten Metallisierung 40 des jeweiligen Substrats 32, 34 angeordnet, wobei jeweils zumindest die zweite Metallisierung 40 als Dickkupfersubstrat ausgeführt ist. Ein derartiges Dickkupfersubstrat weist eine Stärke s1, s2 von mindestens 1 mm auf. Die Kühlkanäle 10, 12, 18, 20 bilden eine geschlossene Kanalstruktur 28 mit einer Zweiphasenkühlung aus, wodurch beispielsweise eine pulsierende Heatpipe ausgebildet wird. Die weitere Ausgestaltung der Halbleiteranordnung 2 in FIG 4 entspricht der in FIG 2.

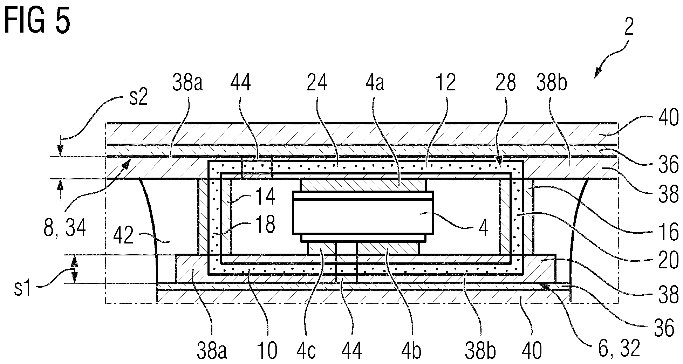

FIG 5 zeigt eine schematische Querschnittsdarstellung einer fünften Ausführungsform einer Halbleiteranordnung 2. Der erste Kühlkanal 10 und der zweite Kühlkanal 12 sind in der ersten Metallisierung 38 des jeweiligen Substrats 32, 34 angeordnet, wobei jeweils zumindest die erste Metallisierung 38 als Dickkupfersubstrat ausgeführt ist. Ein derartiges Dicckupfersubstrat weist eine Stärke s1, s2 von mindestens 1 mm auf. Die elektrisch isolierend voneinander angeordneten Abschnitte 38a, 38b der jeweiligen ersten Metallisierung 38 sind über dielektrische Zwischenstücke 44 verbunden, durch welche der erste Kühlkanal 10 bzw. der zweite Kühlkanal 12 verläuft. Das Wärmetransportmedium 24 ist als ein elektrisch nichtleitendes Fluid ausgeführt. Die Kühlkanäle 10, 12, 18, 20 bilden eine geschlossene Kanalstruktur 28 mit einer Zweiphasenkühlung aus, wodurch beispielsweise eine pulsierende Heatpipe ausgebildet wird. Die weitere Ausgestaltung der Halbleiteranordnung 2 in FIG 4 entspricht der in FIG 2.

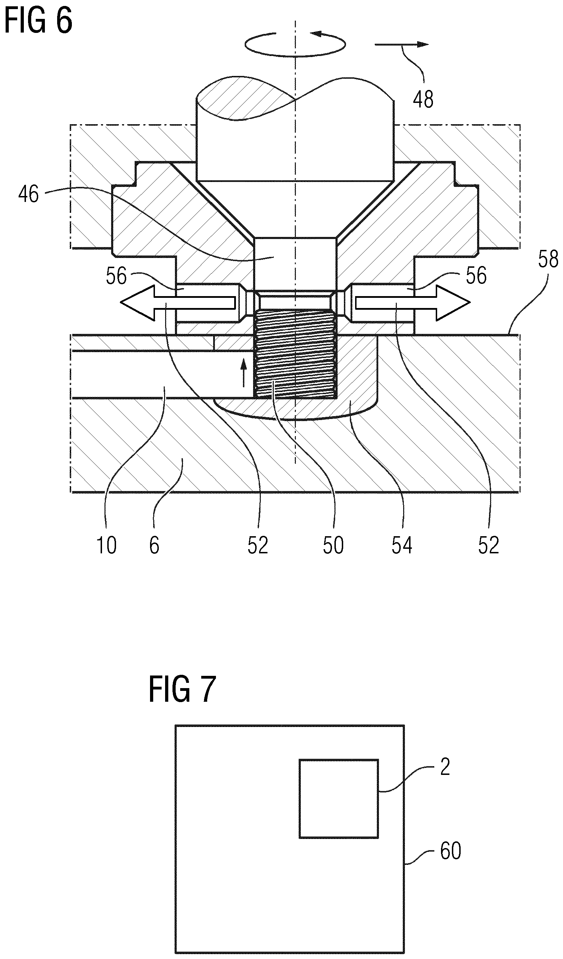

FIG 6 zeigt eine schematische Darstellung einer Herstellung des ersten Kühlkanals 10 in der ersten Materiallage 6 mittels eines FSC-Verfahrens. Eine rotierenden Sonde 46 taucht in die ersten Materiallage 6 ein und wird in eine Bewegungsrichtung 48 verfahren. Durch die Rotationsbewegung eines gewindeartig profilierten rotierenden Stiftes 50 wird der metallische Werkstoff der ersten Materiallage 6 plastifiziert. Es erfolgt eine Extrusion 52 eines Teils des plastifizierten Materials 54, das über eine Extrusionsöffnung 56 ausgestoßen wird. Diese Materialsubtraktion führt zur Ausbildung des geschlossenen, unter der Oberfläche 58 verlaufenden ersten Kühlkanals 10.

FIG 7 zeigt eine schematische Darstellung eines Stromrichters 60, welcher beispielhaft eine Halbleiteranordnung 2 umfasst.

Zusammenfassend betrifft die Erfindung eine Halbleiteranordnung 2 mit zumindest einem Halbleiterelement 4, einer ersten Materiallage 6 und einer zweiten Materiallage 8, wobei das zumindest eine Halbleiterelement 4 zwischen den Materiallagen 6, 8 angeordnet und mit der ersten Materiallage 6 und/oder der zweiten Materiallage 8, insbesondere stoffschlüssig, verbunden ist. Um die Zuverlässigkeit der Halbleiteranordnung 2 bei einer hohen Integrationsdichte zu verbessern, wird vorgeschlagen, dass die erste Materiallage 6 einen ersten Kühlkanal 10 und die zweite Materiallage 8 einen zweiten Kühlkanal 12 aufweist, wobei der zweite Kühlkanal 10 mit dem ersten Kühlkanal 12 in einer fluidtechnischen Verbindung steht.

## Patentansprüche

1. Halbleiteranordnung (2) mit zumindest einem Halbleiterelement (4), einer ersten Materiallage (6) und einer zweiten Materiallage (8),
wobei das zumindest eine Halbleiterelement (4) zwischen den Materiallagen (6, 8) angeordnet und mit der ersten Materiallage (6) und/oder der zweiten Materiallage (8), insbesondere stoffschlüssig, verbunden ist,
**dadurch gekennzeichnet, dass**
die erste Materiallage (6) einen ersten Kühlkanal (10) und die zweite Materiallage (8) einen zweiten Kühlkanal (12) aufweist,
wobei der zweite Kühlkanal (12) mit dem ersten Kühlkanal (10) in einer fluidtechnischen Verbindung steht.

2. Halbleiteranordnung (2) nach Anspruch 1,
wobei die erste Materiallage (6) mit der zweiten Materiallage (8) über zumindest ein Verbindungselement (14) verbunden ist,
wobei das zumindest eine Verbindungselement (14) einen dritten Kühlkanal (18) aufweist, welcher zur Herstellung der fluidtechnischen Verbindung zwischen dem ersten Kühlkanal (10) der ersten Materiallage (6) und dem zweiten Kühlkanal (12) der zweiten Materiallage (8) vorgesehen ist.

3. Halbleiteranordnung (2) nach Anspruch 1 oder 2,
wobei das Verbindungselement (14) aus einem elektrisch isolierenden Werkstoff, insbesondere einem dielektrischen Werkstoff, hergestellt und zur mechanischen Verbindung der ersten Materiallage (6) mit der zweiten Materiallage (8) vorgesehen ist.

4. Halbleiteranordnung (2) nach Anspruch 1 oder 2,
wobei das Verbindungselement (14) aus einem elektrisch leitfähigen Werkstoff, insbesondere einem metallischen Werkstoff, hergestellt und zur elektrisch leitfähigen Verbindung der ersten Materiallage (6) mit der zweiten Materiallage (8) vorgesehen ist.

5. Halbleiteranordnung (2) nach einem der vorhergehenden Ansprüche,
wobei die Kühlkanäle (10, 12, 18) ein elektrisch nichtleitendes Wärmetransportmedium (24) enthalten,
wobei das zumindest eine Halbleiterelement (4) mit dem Wärmetransportmedium (24) in einer thermisch leitfähigen Verbindung steht.

6. Halbleiteranordnung (2) nach Anspruch 5,
wobei die Kühlkanäle (10, 12, 18) mit dem Wärmetransportmedium (24) für eine Zweiphasenkühlung vorgesehen sind.

7. Halbleiteranordnung (2) nach einem der vorhergehenden Ansprüche,
wobei der erste Kühlkanal (10) und/oder der zweite Kühlkanal (12) mittels eines FSC-Verfahrens hergestellt ist.

8. Halbleiteranordnung (2) nach Anspruch 7,
wobei der erste Kühlkanal (10) und/oder der zweite Kühlkanal (12) eine mittels des FSC-Verfahrens hergestellte Öffnung (22) aufweisen,
wobei das Verbindungselement (14) über die Öffnung (22) an den Kühlkanal (10, 12) angebunden ist.

9. Halbleiteranordnung (2) nach einem der vorhergehenden Ansprüche,
wobei die erste Materiallage (6) und/oder die zweite Materiallage (8) ein Substrat (32, 34) umfasst, welches zumindest eine Metallisierung (38, 40) und eine dielektrische Materiallage (36) umfasst.

10. Halbleiteranordnung (2) nach Anspruch 9,
wobei die zumindest eine Metallisierung (38, 40) eines Substrats (32, 34) als Dickkupfersubstrat ausgeführt ist.

11. Stromrichter (60) mit mindestens einer Halbleiteranordnung (2) nach einem der vorherigen Ansprüche.

12. Verfahren zur Herstellung einer Halbleiteranordnung (2) mit zumindest einem Halbleiterelement (4), einer ersten Materiallage (6) und einer zweiten Materiallage (8),
wobei das zumindest eine Halbleiterelement (4) zwischen den Materiallagen (6) angeordnet und mit der ersten Materiallage (6) und/oder der zweiten Materiallage (8), insbesondere stoffschlüssig, verbunden wird,
**dadurch gekennzeichnet, dass**
in der ersten Materiallage (6) ein erster Kühlkanal (10) und der zweiten Materiallage (8) ein zweiter Kühlkanal (12) hergestellt wird,
wobei der zweite Kühlkanal (12) mit dem ersten Kühlkanal (10) fluidtechnisch verbunden wird.

13. Verfahren nach Anspruch 12,
wobei die erste Materiallage (6) mit der zweiten Materiallage (8) über zumindest ein Verbindungselement (14) verbunden wird,
wobei das zumindest eine Verbindungselement (14) einen dritten Kühlkanal (18) aufweist,
wobei der zweiten Kühlkanal (12) mit dem ersten Kühlkanal (10) über den dritten Kühlkanal (18) des Verbindungselements (14) fluidtechnisch verbunden wird.

14. Verfahren nach Anspruch 12 oder 13,
wobei der erste Kühlkanal (10) und/oder der zweite Kühlkanal (12) mittels eines FSC-Verfahrens hergestellt wird.

15. Verfahren nach Anspruch 14,
wobei mittels des FSC-Verfahrens eine Öffnung (22) im ersten Kühlkanal (10) und/oder im zweiten Kühlkanal (12) hergestellt wird,
wobei das Verbindungselement (14) über die Öffnung (22) an den Kühlkanal (10, 12) angebunden wird.
